# EUROPÄISCHE PATENTSCHRIFT

(11) **EP 1 018 120 B1**
(45) Veröffentlichungstag und Bekanntmachung des Hinweises auf die Patenterteilung: **17.10.2001**
(21) Anmeldenummer: 98945058.0
(22) Anmeldetag: 29.07.1998
(51) Int. Cl.: G11C 29/00

(54) **DIGITALER SPEICHER UND BETRIEBSVERFAHREN FÜR EINEN DIGITALEN SPEICHER**
DIGITAL STORAGE AND OPERATING METHOD FOR THE SAME
MEMOIRE NUMERIQUE ET PROCEDE D'EXPLOITATION D'UNE MEMOIRE NUMERIQUE

(30) Priorität: 26.09.1997 DE 19742597
(43) Veröffentlichungstag der Anmeldung: 12.07.2000
(73) Patentinhaber: Infineon Technologies AG, 81669 München (DE)
(72) Erfinder: ZIBERT, Martin, D-83620 Feldkirchen-Westerham (DE); JOHNSON, Bret, D-81737 München (DE)
(86) Internationale Anmeldenummer: DE9802156
(87) Internationale Veröffentlichungsnummer: WO9917297

(56) Entgegenhaltungen:
- EP-A- 0 471 540
- US-A- 5 255 271
- US-A- 5 537 053

## Beschreibung

Die Erfindung betrifft einen digitalen Speicher und ein Betriebsverfahren für einen digitalen Speicher.

Für dynamische Speicher (DRAMs) sind nach einer JEDEC-Norm Betriebsarten vorgesehen, die durch den Speicherhersteller festgelegt werden können. Die JEDEC-Norm gibt lediglich vor, auf welche Weise von einer Normalbetriebsart in diese zusätzlichen Betriebsarten gewechselt werden kann. Oftmals handelt es sich bei diesen Betriebsarten um herstellerspezifische. Testbetriebsarten. Gemäß der JEDEC-Norm erfolgt ein Wechsel in diese Betriebsarten durch Anlegen vorgegebener Signalkombiniationen an die standardmäßig vorhandenen externen Anschlüssen des DRAMs.

Beim Betrieb eines Speichers und insbesondere bei einem Test des Speichers ist es wünschenswert, feststellen zu können, ob ein beabsichtigter Wechsel der Betriebsarten tatsächlich stattgefunden hat, oder auch, ob ein unbeabsichtigter Wechsel zufällig eingetreten ist. Hierbei besteht jedoch das Problem, daß die Zahl der externen Anschlüsse eines DRAMs begrenzt ist, so daß unter Umständen keiner von ihnen zur Ausgabe eines entsprechenden Statussignals, das Auskunft über die jeweilige Betriebsart geben könnte, verwendet werden kann.

Aus dem Dokument US-A-5 537 053, welches die Basis für den Oberbegriff des Patentanspruchs 1 bildet, ist ein digitaler Speicher bekannt, bei dem eine spezielle Betriebsart dadurch signalisiert wird, daß während eines Datenausgabezykluses ein Übergang von einem niederohmigen Zustand eines Ausganges zu einem hochohmigen Zustand verzögert erfolgt.

Der Erfindung liegt die Aufgabe zugrunde, einen integrierten Speicher und ein entsprechendes Betriebsverfahren anzugeben, bei dem ein Erkennen unterschiedlicher Betriebsarten von auβerhalb des Speichers ohne den Einsatz zusätzlicher externer Anschlüsse möglich ist.

Diese Aufgabe wird mit einem digitalen Speicher gemäß Anspruch 1 und einem Betriebsverfahren für einen digitalen Speicher gemäß Anspruch 2 gelöst. Ausführungsformen und Weiterbildungen der Erfindung sind Gegenstand von abhängigen Ansprüchen.

Der erfindungsgemäße digitale Speicher weist Datenleitungen zum Schreiben von Daten in den Speicher und zum Lesen von Daten aus dem Speicher auf und Adreßleitungen zur Adressierung des Speichers beim Lesen und Schreiben. Weiterhin weist er wenigstens eine Schaltungseinheit auf, die in einem aktiven Zustand Signale auf wenigstens einer der Datenleitung oder auf wenigstens einer der Adreßleitungen invertiert, und die in einem inaktiven Zustand die Signale unbeeinflußt läßt. In einer ersten Betriebsart des Speichers befindet sich die Schaltungseinheit sowohl beim Schreiben als auch beim Lesen in demselben Zustand (aktiv oder inaktiv). In einer zweiten Betriebsart dagegen befindet sich die Schaltungseinheit beim Schreiben und beim Lesen in jeweils entgegengesetzten Zuständen.

Der erfindungsgemäße Speicher verhält sich in der ersten Betriebsart also wie ein herkömmlicher Speicher, bei dem gespeicherte Daten mit demselben Zustand wieder ausgelesen werden, mit dem sie in den Speicher eingeschrieben worden sind. Bezüglich der zweiten Betriebsart sind zwei Ausführungsformen der Erfindung zu unterscheiden, die bei herkömmlichen Speichern keine Entsprechung haben: Bei der ersten Ausführungsform wird nur in der zweiten Betriebsart entweder beim Schreiben oder beim Lesen das Signal auf einer oder mehrerer der Datenleitungen invertiert. Von außerhalb des Speichers ist dann durch Vergleich der eingeschriebenen Daten mit den ausgelesenen Daten leicht feststellbar, in welcher Betriebsart sich der Speicher befindet.

Bei der zweiten Ausführungsform des Speichers erfolgt in der zweiten Betriebsart entweder beim Schreiben oder beim Lesen eine Invertierung der Daten auf wenigstens einer der Adreßleitungen. Das bedeutet, daß beim Schreiben und Lesen in der zweiten Betriebsart mit derselben externen Adresse jeweils unterschiedliche Speicherzellen des Speichers adressiert werden. Sind in diesen unterschiedlichen Speicherzellen zuvor zueinander komplementäre Daten eingeschrieben worden, kann von außerhalb des Speichers wiederum ohne großen Aufwand ein Wechsel in die zweite Betriebsart nachgewiesen werden.

Beim erfindungsgemäßen Betriebsverfahren erfolgt in einer ersten Betriebsart des digitalen Speichers bei Anlegen einer Adresse während eines Lesevorgangs ein Auslesen von Daten, die zuvor unter dieser Adresse eingeschrieben wurden, mit unverändertem logischen Zustand. In einer zweiten Betriebsart dagegen werden bei Anlegen einer Adresse während eines Lesevorgangs Daten ausgelesen, die invers zu zuvor unter dieser externen Adresse eingeschriebenen Daten sind.

Nach einer ersten Ausführungsform des Betriebsverfahrens werden in der zweiten Betriebsart Daten entweder beim Schreiben oder beim Lesen invertiert.

Nach einer zweiten Ausführungsform des Betriebsverfahrens werden in der zweiten Betriebsart bei Anlegen einer Adresse während eines Lesevorgangs Daten aus anderen Speicherzellen ausgelesen, als zuvor beim Schreiben mit dieser Adresse adressiert wurden. Dagegen werden in der ersten Betriebsart beim Schreiben und Lesen mit derselben Adresse auch jeweils dieselben Speicherzellen adressiert. Bei einer Weiterbildung dieser zweiten Ausführungsform des Betriebsverfahrens werden in einen ersten Speicherbereich des Speichers Daten eines ersten logischen Zustands und in einen zweiten Speicherbereich des Speichers Daten eines zweiten logischen Zustands geschrieben. Anschließend werden in der zweiten Betriebsart während eines Lesevorgangs durch Anlegen einer bei einem Schreibvorgang dem ersten Speicherbereich zugeordneten Adresse Daten aus dem zweiten Speicherbereich ausgelesen. Auf diese Weise wird erreicht, daß in der zweiten Betriebsart Daten ausgelesen werden, die invers zu denjenigen sind, die unter derselben externen Adresse zuvor in den Speicher hineingeschrieben wurden.

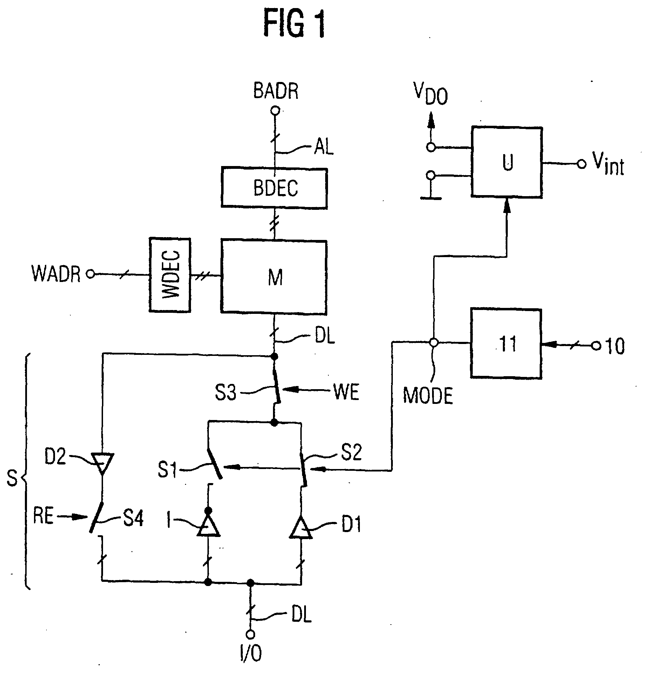

Die Erfindung wird im folgenden anhand der Figuren 1 bis 3, die Ausführungsbeispiele der Erfindung zeigen, näher erläutert.

Figur 1 zeigt ein erstes Ausführungsbeispiel des erfindungsgemäßen Speichers. Es handelt sich um ein DRAM. Dieses weist einen Speicherbereich M mit (nicht dargestellten) matrixförmig angeordneten Wort- und Bitleitungen auf, in deren Kreuzungspunkten Speicherzellen angeordnet sind. Die Bitleitungen sind über externe Bitadressen BADR und einen entsprechenden Spaltendecoder BDEC, dem die Bitadressen BADR über Adreßleitungen AL zugeführt werden, selektierbar. Eine Auswahl der Wortleitungen erfolgt durch externe Wortadressen WADR über einen Zeilendecoder WDEC.

Aus dem Speicherbereich M auszulesende oder in diesen hineinzuschreibende Daten gelangen über bidirektionale Datenleitungen DL an Ein-/Ausgänge I/O des Speichers. Die Datenleitungen DL sind über eine Schaltungseinheit S geführt, die drei parallele Zweige je Datenleitung DL enthält.

Der mittlerer und der rechte Zweig der Schaltungseinheit S dienen dem Einschreiben von Daten in den Speicher. Der mittlere Zweig weist in einer Reihenschaltung einen invertierenden Treiber I und einen ersten Schalter S1 auf. Der rechte Zweig weist einen ersten nichtinvertierenden Treiber D1 und einen zweiten Schalter S2 auf. Der erste Schalter S1 und der zweite Schalter S2 sind nie gleichzeitig geschlossen, wie weiter unten noch erläutert wird. Der mittlere und der rechte Zweig sind mit einem dritten Schalter S3 verbunden, der durch ein Schreibsignal WE gesteuert wird. Das Schreibsignal WE bewirkt, daß der dritte Schalter bei Schreibzugriffen auf den Speicher geschlossen und sonst geöffnet ist. Das bedeutet, daß die Stellung des ersten S1 und zweiten S2 Schalters nur bei geschlossenem dritten Schalter S3 von Bedeutung ist.

Der linke Zweig der Schaltungseinheit S dient dem Auslesen von Daten aus dem Speicher und weist einen zweiten nichtinvertierenden Treiber D2 und einen vierten Schalter S4 auf. Der vierte Schalter S4 ist in Abhängigkeit eines Lesesignals RE bei Lesezugriffen auf den Speicher geschlossen. Die Schalter S1, S2, S3, S4 können beispielsweise durch Transistoren oder logische Gatter realisiert sein.

Weiterhin weist der Speicher einen Spannungsregler U auf, der aus externen Versorgungspotentialen VDD, Masse des Speichers ein internes Versorgungspotential V_{INT} erzeugt. Das interne Versorgungspotential V_{INT} ist in einer ersten Betriebsart des Speichers kleiner als in einer zweiten Betriebsart. Ein Wechsel zwischen den beiden Betriebsarten erfolgt in Abhängigkeit von Steuersignalen an externen Anschlüssen 10 des Speichers. Die externen Anschlüsse 10 sind mit einer Betriebsarterkennungseinheit 11 verbunden, die ein Betriebsartsignal MODE erzeugt. Ein Betriebsartwechsel kann beispielsweise durch Anlegen einer in einer entsprechenden JEDEC-Norm vorgesehene Signalkombination an die externen Anschlüsse 10 erfolgen. Die externen Anschlüsse 10 können teilweise oder vollständig mit den Ein-/Ausgängen I/O oder den Adreßanschlüssen BADR, WADR übereinstimmen. Das Betriebsartsignal MODE steuert den Spannungsregler U.

Das Betriebsartsignal MODE dient außerdem zum Steuern des ersten Schalters S1 und des zweiten Schalters S2. Es öffnet und schließt diese beiden Schalter S1, S2 jeweils wechselweise. Immer, wenn das Betriebsartsignal MODE einen niedrigen Pegel hat, haben die Schalter S1, S2 die in Figur 1 gezeigte Stellung; d.h. der erste Schalter S1 ist geöffnet (mittlerer Zweig der Schaltungseinheit S deaktiviert) und der zweite Schalter S2 ist geschlossen (rechter Zweig aktiviert). Hat das Betriebsartsignal MODE dagegen einen hohen Pegel, ist der erste Schalter S1 geschlossen und der zweite Schalter S2 geöffnet.

Hat das Betriebsartsignal MODE einen niedrigen Pegel, befindet sich der Speicher in der ersten Betriebsart und Daten werden sowohl beim Lesen (über den linken Zweig) als auch beim Schreiben (über den rechten Zweig) nichtinvertiert über die Datenleitungen DL übertragen.

Hat das Betriebsartsignal MODE jedoch einen hohen Pegel (zweite Betriebsart), schalten beide Schalter S1, S2 um, so daß der mittlere Zweig der Schaltungseinheit S aktiv wird. Während zu lesende Daten weiterhin über den linken Zweig übertragen werden, werden einzuschreibende Daten nun über den mittleren Zweig der Schaltungseinheit S übertragen.

Das bedeutet, daß in der ersten Betriebsart Daten bei der Übertragung über die Datenleitungen DL weder beim Schreiben noch beim Lesen durch die Schaltungseinheit S invertiert werden. In der zweiten Betriebsart dagegen werden Daten über den Inverter I immer invertiert in den Speicherbereich M eingeschrieben, aber über den linken Zweig der Schaltungseinheit S, das heißt ohne Invertierung, wieder ausgelesen.

Legt man nun beispielsweise an die Ein-/Ausgänge I/O während eines Schreibvorgangs Daten vom logischen Zustand "1", die in einen Teil oder alle Speicherzellen des Speicherbereiches M geschrieben werden, und liest anschließend diese Speicherzellen wieder aus, erhält man in der ersten Betriebsart an den Ein-/Ausgängen I/O wiederum Daten des Zustands logisch "1", während die ausgelesenen Daten in der zweiten Betriebsart den Zustand "0" haben. Durch Vergleich der eingeschriebenen mit den wieder ausgelesenen Daten kann also unter Verwendung der vorhandenen externen Anschlüssen des Speichers erkannt werden, in welcher Betriebsart er sich befindet. Handelt es sich um eine größere Anzahl von Speicherzellen, die auf diese Weise beschrieben und wieder ausgelesen werden, können Einflüsse von Speicherfehlern auf das Ergebnis des Vergleichs vernachlässigt werden.

Bei anderen Ausführungsbeispielen der Erfindung ist es auch möglich, daß nur für einen oder einige der Datenleitungen DL des Speichers eine entsprechende Invertertierung durch die Schaltungseinheit S vorgesehen ist.

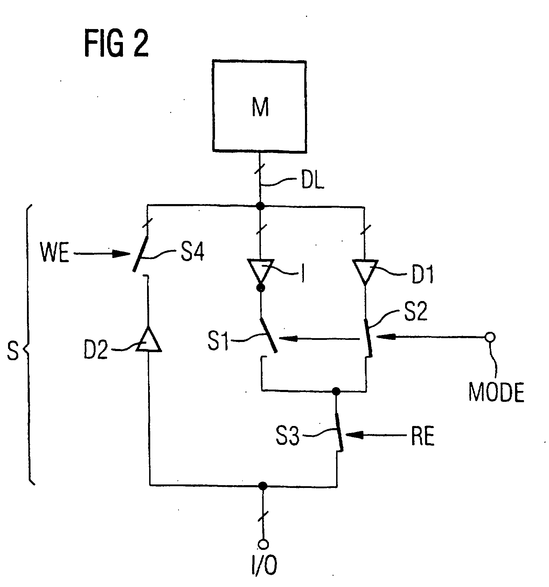

Figur 2 zeigt ein zweites Ausführungsbeispiel der Erfindung. Dieses unterscheidet sich von demjenigen in Figur 1 nur hinsichtlich seiner Schaltungseinheit S, weswegen die übrigen Komponenten nicht noch einmal dargestellt wurden. Diesmal dienen der mittlere und der rechte Zweig der Schaltungseinheit S dem Auslesen von Daten aus dem Speicher. Der dritte Schalter S3 wird jetzt durch das Lesesignal RE gesteuert. Entsprechend dient der linke Zweig der Schaltungseinheit S dem Einschreiben von Daten, wobei der vierte Schalter S4 durch das Schreibsignal WE gesteuert wird.

Die Funktion des Speichers in Figur 2 ist analog zur Funktion des Speichers aus Figur 1. Eine Überprüfung der Betriebsart erfolgt auch hier durch Einschreiben von Daten eines bestimmten logischen Zustands in den Speicher und anschließendes Auslesen. Werden die Daten beim Auslesen invertiert, befindet sich der Speicher in der zweiten Betriebsart, ansonsten befindet er sich in der ersten Betriebsart.

Werden in der zweiten Betriebsart, wie bei den hier erläuterten Ausführungsbeispielen, sämtliche Daten beim Schreiben oder Lesen durch die Schaltungseinheit S invertiert, kann ein Test des Speichers grundsätzlich in beiden Betriebsarten erfolgen. Die in der zweiten Betriebsart bewirkte einfache Invertierung beeinflußt nämlich den Test nicht. Die Detektion der Betriebsart erfolgt durch Vergleich der eingeschriebenen mit den wieder ausgelesenen Daten. Anschließend kann die gegebenenfalls in der zweiten Betriebsart erfolgte Invertierung bei der Auswertung der Testergebnisse berücksichtigt werden.

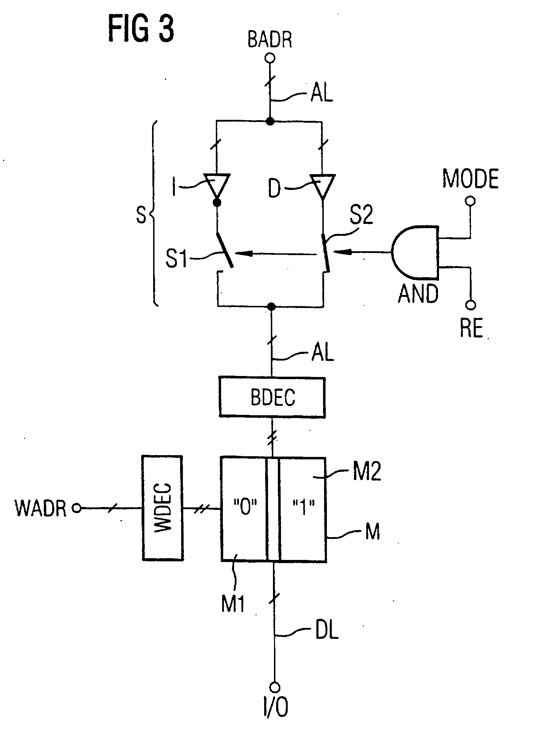

Figur 3 zeigt ein drittes Ausführungsbeispiel des erfindungsgemäßen Speichers. Komponenten mit gleichen Bezugszeichen haben die gleiche Bedeutung wie bei den Speichern in Figur 1 und 2. Daher wird im folgenden nur auf die Unterschiede zu Figur 1 eingegangen. Beim Speicher in Figur 3 erfolgt durch die Schaltungseinheit S statt einer Invertierung der Signale auf den Datenleitungen DL eine Invertierung der Bitadressen BADR auf den Adreßleitungen AL. Dies geschieht nur in der zweiten Betriebsart und nur bei einem Lesevorgang, wie im folgenden erläutert wird.

Die Schaltungseinheit S weist einen linken Zweig auf mit einem invertierenden Treiber I und einem ersten Schalter S1 und einen rechten Zweig mit einem nichtinvertierenden Treiber D und einem zweiten Schalter S2. Einem UND-Gatter AND wird das Betriebsartsignal MODE und das Lesesignal RE zugeführt, das bei einem Lesevorgang des Speichers einen hohen Pegel und sonst einen niedrigen Pegel aufweist. Ein Ausgang des UND-Gatters AND ist mit Steuereingängen der Schalter S1, S2 verbunden. Befindet sich der Speicher in Figur 3 in der ersten Betriebsart, hat das Betriebsartsignal einen niedrigen Pegel, und die Schalter S1, S2 befinden sich in der dargestellten Stellung. Das gleiche gilt in der zweiten Betriebsart, in der das Betriebsartsignal MODE einen hohen Pegel aufweist, während eines Schreibvorgangs, bei dem das Lesesignal RE einen niedrigen Pegel aufweist. Erfolgt dagegen in der zweiten Betriebsart ein Lesezugriff (Lesesignal RE hat einen hohen Pegel), schließt der erste Schalter S1 und der zweite Schalter S2 öffnet.

Bei anderen Ausführungsbeispielen der Erfindung kann beim Speicher nach Figur 3 das UND-Gatter AND auch statt mit dem Lesesignal RE mit dem Schreibsignal WE verbunden sein. Dann erfolgt eine Invertierung der Adressen BADR in der zweiten Betriebsart nur bei Schreibzugriffen auf den Speicher.

Der Speicherbereich M in Figur 3 ist in einen ersten Speicherbereich M1 und einen zweiten Speicherbereich M2 aufgeteilt. Um feststellen zu können, in welcher Betriebsart sich der Speicher befindet, werden in die Speicherzellen des ersten Speicherbereiches M1 logische Nullen und in die Speicherzellen des zweiten Speicherbereiches M2 logische Einsen eingeschrieben. Dabei ist der zweite Schalter S2 geschlossen und der erste Schalter S1 geöffnet. Anschließend erfolgt ein Auslesen der Speicherbereiche M1, M2. In der ersten Betriebsart, in der das Betriebsartsignal MODE einen niedrigen Pegel hat, ist die Stellung der Schalter S1, S2, unabhängig vom Lesesignal RE, die in Figur 2 gezeigte. Es findet also keine Invertierung der Bitadressen BADR statt.

Da das Lesesignal RE bei einem Lesevorgang einen hohen Pegel äüfweist, ändert sich in der zweiten Betriebsart (Betriebsartsignal MODE hat einen hohen Pegel) beim Lesen die Stellung der Schalter S1, S2 gegenüber dem in Figur 2 gezeigten Zustand, so daß anschließend der erste Schalter S1 geschlossen und der zweite Schalter S2 geöffnet ist. Dies hat zur Folge, daß die extern anliegenden Bitadressen BADR beim Auslesen dem Spaltendecoder BDEC invertiert zugeführt werden, so daß jeweils statt Speicherzellen des ersten Speicherbereiches M1 solche des zweiten Speicherbereiches M2 (und umgekehrt) adressiert werden. Da in beiden Speicherbereichen M1, M2 zueinander komplementäre Daten gespeichert sind, kann durch Vergleich der über die Ein-/Ausgänge I/O des Speichers in diesen hineingeschriebenen und wieder ausgelesenen Daten leicht festgestellt werden, in welcher der beiden Betriebsarten sich der Speicher derzeit befindet.

Bei anderen Ausführungsbeispielen der Erfindung reicht es aus, wenn statt einer Invertierung aller Bits der Bitadressen BADR, wie in Figur 2 gezeigt, lediglich ein Bit der Bitadresse BADR invertiert wird. Natürlich können statt der Bitadressen BADR auch die Wortadressen WADR oder beide Adreßarten entsprechend invertiert werden.

Bei Abwandlungen des Ausführungsbeispiels in Figur 3 können die Adressen BADR in der ersten Betriebsart sowohl beim Schreiben als auch beim Lesen durch die Schaltungseinheit S invertiert werden und in der zweiten Betriebsart nur beim Lesen oder nur beim Schreiben.

## Patentansprüche

1. Digitaler Speicher
- mit wenigstens einer Datenleitung (DL) zum Schreiben von Daten in den Speicher und zum Lesen von Daten aus dem Speicher,
- mit Adreßleitungen (AL) zur Adressierung des Speichers beim Lesen und Schreiben, **gekennzeichnet durch**
- eine Schaltungseinheit (S), die in einem aktiven Zustand Signale auf wenigstens einer der Datenleitungen (DL) oder auf wenigstens einer der Adreßleitungen (AL) invertiert und die in einem inaktiven Zustand die Signale unbeeinflußt läßt,
- eine erste Betriebsart, in der sich die Schaltungseinheit (S) beim Schreiben und Lesen in demselben Zustand befindet,
- und eine zweite Betriebsart, in der sich die Schaltungseinheit (S) beim Schreiben und beim Lesen in jeweils entgegengesetzten Zuständen befindet.

2. Betriebsverfahren für einen digitalen Speicher,
bei dem
- in einer ersten Betriebsart bei Anlegen einer Adresse (BADR, WADR) während eines Lesevorgangs Daten, die zuvor unter dieser Adresse eingeschrieben wurden, mit unverändertem logischen Zustand ausgelesen werden
- und in einer zweiten Betriebsart bei Anlegen einer Adresse während eines Lesevorgangs Daten ausgelesen werden, die invers zu zuvor unter dieser Adresse eingeschriebenen Daten sind.

3. Verfahren nach Anspruch 2,
bei dem
- in der ersten Betriebsart Daten mit gleichem logischen Zustand ausgelesen werden, mit dem sie zuvor eingeschrieben wurden,
- und in der zweiten Betriebsart Daten beim Lesen im Vergleich zum Schreiben invertiert werden.

4. Verfahren nach Anspruch 2,
bei dem
- in der ersten Betriebsart bei Anlegen von Adressen (BADR, WADR) während eines Lesevorgangs dieselben Speicherzellen adressiert werden, wie beim Anlegen derselben Adressen während eines Schreibvorgangs,
- und in der zweiten Betriebsart bei Anlegen von Adressen während eines Lesevorgangs andere Speicherzellen adressiert werden, als beim Anlegen derselben Adresse während eines Schreibvorgangs.

5. Verfahren nach Anspruch 4,
bei dem
- in einen ersten Speicherbereich (M1) des Speichers Daten eines ersten logischen Zustands (0) und in einen zweiten Speicherbereich (M2) des Speichers Daten eines zweiten logischen Zustands (1) geschrieben werden
- und in der zweiten Betriebsart während eines Lesevorgangs durch Anlegen einer bei einem Schreibvorgang dem ersten Speicherbereich (M1) zugeordneten Adresse (BADR, WADR) Daten aus dem zweiten Speicherbereich (M2) ausgelesen werden.

## Claims

1. Digital memory
- having at least one data line (DL) for writing data to the memory and for reading data from the memory,
- having address lines (AL) for addressing the memory for reading and writing, **characterized by**
- a switching unit (S) which, in an active state, inverts signals on at least one of the data lines (DL) or on at least one of the address lines (AL) and which, in an inactive state, leaves the signals unchanged,
- a first operating mode, in which the switching unit (S) is in the same state for writing and reading,
- and a second operating mode, in which the switching unit (S) is in respectively opposite states for writing and for reading.

2. Method of operation for a digital memory, in which,
- in a first operating mode, when an address (BADR, WADR) is applied during a read operation, data which has previously been written under this address is read with an unchanged logic state,
- and, in a second operating mode, when an address is applied during a read operation, data which is the inverse of data previously written under this address is read.

3. Method according to Claim 2, in which,
- in the first operating mode, data is read with the same logic state as that with which it was previously written,
- and, in the second operating mode, data for reading is inverted in comparison with writing.

4. Method according to Claim 2, in which,
- in the first operating mode, when addresses (BADR, WADR) are applied during a read operation, the same memory cells are addressed as when the same addresses are applied during a write operation,
- and, in the second operating mode, when addresses are applied during a read operation, different memory cells are addressed than when the same address is applied during a write operation.

5. Method according to Claim 4, in which
- data having a first logic state (0) is written to a first memory area (M1) of the memory, and data having a second logic state (1) is written to a second memory area (M2) of the memory,
- and, in the second operating mode, data is read from the second memory area (M2) during a read operation as a result of an address (BADR, WADR) associated with the first memory area (M1) in a write operation being applied.

## Revendications

1. Mémoire numérique
- comprenant au moins une ligne (DL) de données pour écrire des données dans la mémoire et pour lire des données dans la mémoire,
- des lignes (AL) d'adresse pour adresser la mémoire lors de la lecture et de l'écriture, **caractérisée par**
- une unité (S) de commutation qui, dans un état actif, inverse des signaux sur au moins l'une des lignes (DL) de données ou sur au moins l'une des lignes (AL) d'adresse et qui laisse intacts les signaux dans un état inactif,
- un premier type de fonctionnement dans lequel l'unité (S) de commutation se trouve dans le même état à l'écriture et à la lecture,
- et un deuxième type de fonctionnement dans lequel l'unité (S) de commutation se trouve dans des états respectivement opposés à l'écriture et à la lecture.

2. Procédé pour faire fonctionner une mémoire numérique, dans lequel
- dans un premier type de fonctionnement lors de l'élaboration d'une adresse (BADR, WADR) on lit pendant une opération de lecture des données qui ont été écrites auparavant à cette adresse et qui ont un état logique inchangé,
- et dans un deuxième type de fonctionnement lors de l'élaboration d'une adresse on lit pendant une opération de lecture des données qui sont inverses des données écrites auparavant à cette adresse.

3. Procédé suivant la revendication 2, dans lequel
- dans le premier type de fonctionnement, on lit des données ayant le même état logique que celui dans lequel elles ont été écrites auparavant,
- et dans le deuxième type de fonctionnement on inverse des données à la lecture par rapport à l'écriture.

4. Procédé suivant la revendication 2, dans lequel
- dans le premier type de fonctionnement lors de l'élaboration d'adresse (BADR, WADR) on adresse pendant une opération de lecture les mêmes cellules de mémoire que lors de l'élaboration des mêmes adresses pendant une opération d'écriture,
- et dans le deuxième type de fonctionnement lors de l'élaboration d'adresse, on adresse pendant une opération de lecture d'autres cellules de mémoire que lors de l'élaboration des mêmes adresses pendant une opération d'écriture.

5. Procédé suivant la revendication 4, dans lequel
- dans une première partie (M1) de la mémoire on écrit des données d'un premier état haut logique et dans une deuxième partie (M2) de la mémoire on écrit des données d'un deuxième état (1) logique,
- et dans le deuxième type de fonctionnement pendant une opération de lecture, par l'élaboration d'une adresse (BADR, WADR) associée lors de l'opération d'écriture à la première partie (M1) de la mémoire, on lit des données dans la deuxième partie (M2) de la mémoire.
